# EUROPÄISCHE PATENTANMELDUNG

(11) **EP 1 281 663 A2**
(43) Veröffentlichungstag der Anmeldung: **05.02.2003**
(21) Anmeldenummer: 02012141.4
(22) Anmeldetag: 01.06.2002
(51) Int. Cl.: B81B 1/00, B81C 1/00

(54) **Verfahren zum Erzeugen von mikromechanischen Strukturen**

(30) Priorität: 24.07.2001 DE 10136016
(71) Anmelder: ROBERT BOSCH GMBH, 70442 Stuttgart (DE)
(72) Erfinder: Leinenbach, Patrick, 72766 Reutlingen (DE); Laermer, Franz, 71263 Weil der Stadt (DE); Urban, Andrea, 70563 Stuttgart (DE); Graf, Eckhard, 72810 Gomaringen (DE); Senay, Nevzat, 72762 Reutlingen (DE)

(57) **Zusammenfassung**

Mit der vorliegenden Erfindung wird ein Verfahren vorgeschlagen, mit dem unterschiedliche Strukturen, wie z.B. Grobstrukturen und Feinstrukturen, unabhängig voneinander in einem Siliziumwafer oder in der Funktionsschicht eines Schichtaufbaus für Oberflächenmikromechanik erzeugt werden können.

Dazu wird der Siliziumwafer (1) bzw. die Funktionsschicht zunächst mit mindestens einer ersten Maskierschicht versehen, die so strukturiert wird, dass ein Teil der zu erzeugenden Strukturen (11 bis 17) in einem Ätzvorgang erzeugt werden kann. Der so maskierte Siliziumwafer (1) bzw. die so maskierte Funktionsschicht wird dann mindestens einem ersten Ätzvorgang unterzogen, nach dem die entsprechende erste Maskierschicht entfernt wird. Erfindungsgemäß wird der Siliziumwafer (1) bzw. die Funktionsschicht nach dem mindestens einen ersten Ätzvorgang und dem Entfernen der mindestens einen ersten Maskierschicht mindestens einmal mit einer weiteren Maskierschicht (3) versehen, so dass die bereits erzeugten Strukturen (11 bis 16) gegen einen weiteren Ätzangriff geschützt sind. Diese weitere Maskierschicht (3) wird strukturiert, bevor der so maskierte Siliziumwafer (1) bzw. die so maskierte Funktionsschicht einem weiteren Ätzvorgang unterzogen wird und die weitere Maskierschicht (3) nach dem weiteren Ätzvorgang entfernt wird.

## Beschreibung

### Stand der Technik

Die Erfindung betrifft ein Verfahren zum Erzeugen von mikromechanischen Strukturen in einem Siliziumwafer oder in der Funktionsschicht eines Schichtaufbaus für Oberflächenmikromechanik, wobei der Siliziumwafer bzw. die Funktionsschicht mit mindestens einer ersten Maskierschicht versehen wird, die so strukturiert wird, dass ein Teil der zu erzeugenden mikromechanischen Strukturen in einem Ätzvorgang erzeugt werden kann, und wobei der so maskierte Siliziumwafer bzw. die so maskierte Funktionsschicht mindestens einem ersten Ätzvorgang unterzogen wird, nach dem die entsprechende erste Maskierschicht entfernt wird.

Es ist aus der Praxis bekannt, verschiedene Strukturen, wie z.B. Feinstrukturen und Grobstrukturen, in aufeinanderfolgenden Ätzvorgängen in einem Siliziumwafer oder der Funktionsschicht eines Schichtaufbaus für Oberflächenmikromechanik zu erzeugen. Als Funktionsschicht kann beispielsweise eine Polysiliziumschicht dienen. Für jeden dieser Ätzvorgänge ist in der Regel eine eigene Maskierschicht vorgesehen. Diese Maskierschichten werden vor dem ersten Ätzvorgang nacheinander - also übereinander - auf die Waferoberfläche bzw. die Oberfläche der Funktionsschicht aufgebracht und entsprechend der jeweils zu erzeugenden Struktur strukturiert.

Das bekannte Verfahren wird nachfolgend am Beispiel eines Siliziumwafers erläutert, in dem mit Hilfe eines Tieftrench-Ätzvorgangs eine Grobstruktur und mit Hilfe eines Flachtrench-Ätzvorgangs eine Feinstruktur erzeugt werden sollen. Dazu wird zunächst eine erste Maskierschicht auf die Waferoberfläche aufgebracht, die für den Flachtrench-Ätzvorgang bestimmt ist. Nach Strukturierung der ersten Maskierschicht wird auf die erste Maskierschicht eine zweite Maskierschicht aufgebracht, die für den Tieftrench-Ätzvorgang bestimmt ist. Die zweite Maskierschicht wird ausschließlich entsprechend der Geometrie der Grobstruktur strukturiert. Im Gegensatz dazu müssen bei der Strukturierung der ersten Maskierschicht sowohl die Geometrie der Feinstruktur als auch die Geometrie der Grobstruktur berücksichtigt werden, da der erste Ätzangriff, der Tieftrench zum Erzeugen der Grobstruktur, durch die zweite Maskierschicht und die darunter liegende erste Maskierschicht erfolgt. Nach dem Tieftrench wird die zweite Maskierschicht entfernt, so dass die Waferoberfläche beim zweiten Ätzangriff; dem Flachtrench zum Erzeugen der Feinstruktur, nur noch durch die erste Maskierschicht geschützt wird. Da die bereits erzeugte Grobstruktur nicht maskiert ist, wird die Grobstruktur auch beim Flachtrench mitgeätzt. Dabei kommt es häufig zu unerwünschten Unterätzungen der Grobstruktur, insbesondere im unteren Bereich der Ätzausnehmungen, und zu Verbreiterungen der Ätzausnehmungen.

Durch die Notwendigkeit des bekannten Verfahrens, alle Maskierschichten vor dem ersten Ätzvorgang auf die Waferoberfläche aufzubringen und nach jedem Ätzvorgang die jeweils oberste Maskierschicht einzeln zu entfernen, wird die Prozessführung stark eingeschränkt. Für die Maskierschichten müssen unterschiedliche Materialien verwendet werden, die ein selektives Entfernen der einzelnen Maskierschichten ermöglichen. Dadurch ist die Anzahl der nacheinander durchführbaren Ätzvorgänge begrenzt. Außerdem können beim selektiven Entfernen der einzelnen Maskierschichten Partikel zurückbleiben, die bei einem nachfolgenden Ätzvorgang als unerwünschte Maskierung Defekte verursachen.

Als besonders problematisch erweist sich, dass die einzelnen Ätzvorgänge des bekannten Verfahrens bzw. die dabei erzeugten Strukturen nicht unabhängig voneinander sind. So müssen vor den Feinstrukturen immer zunächst die Grobstrukturen erzeugt werden. Wie bereits erwähnt, werden die einmal erzeugten Strukturen nicht gegen einen weiteren Ätzangriff geschützt, so dass sie dabei zwangsläufig mitgeätzt werden. Während eine solche Überätzung bei Grobstrukturen zwar zu unerwünschten Strukturveränderungen führen kann aber zumindest in gewissem Maße tolerierbar ist, führt eine Überätzung bei Feinstrukturen in der Regel zu deren Zerstörung. Außerdem können mit dem bekannten Verfahren im Bereich einer geätzten Grobstruktur keine Feinstrukturen mehr erzeugt werden.

### Vorteile der Erfindung

Mit der vorliegenden Erfindung wird ein Verfahren vorgeschlagen, mit dem unterschiedliche Strukturen, wie z.B. Grobstrukturen und Feinstrukturen, unabhängig voneinander in einem Siliziumwafer oder auch in der Funktionsschicht eines Schichtaufbaus für Oberflächenmikromechanik erzeugt werden können.

Dies wird erfindungsgemäß dadurch erreicht, dass der Siliziumwafer bzw. die Funktionsschicht nach dem mindestens einen ersten Ätzvorgang und dem Entfernen der mindestens einen ersten Maskierschicht mindestens einmal mit einer weiteren Maskierschicht versehen wird, so dass die bereits erzeugten Strukturen gegen einen weiteren Ätzangriff geschützt sind. Diese weitere Maskierschicht wird strukturiert, bevor der so maskierte Siliziumwafer bzw. die so maskierte Funktionsschicht einem weiteren Ätzvorgang unterzogen wird und die weitere Maskierschicht nach dem weiteren Ätzvorgang entfernt wird.

Erfindungsgemäß werden die unterschiedlichen mikromechanischen Strukturen nacheinander in unterschiedlichen Ätzvorgängen erzeugt. Eine einmal erzeugte Struktur wird durch eine entsprechende Maskierschicht vor einem weiteren Ätzangriff geschützt, soweit die Struktur nicht mehr gezielt verändert werden soll. Dadurch sind die einzelnen Ätzvorgänge vollkommen unabhängig voneinander. Die Anzahl der Ätzvorgänge des erfindungsgemäßen Verfahrens wird also nicht beschränkt durch unkontrollierte Auswirkungen auf bereits erzeugte Strukturen, so dass insgesamt mikromechanische Strukturen erzeugt werden können, deren Komplexität weit über die Komplexität der mit dem bekannten Verfahren realisierbaren Strukturen hinausgeht.

Grundsätzlich gibt es verschiedene Möglichkeiten für die Realisierung und für Ausgestaltungen des erfindungsgemäßen Verfahrens. Besonders vorteilhafte Varianten sind mit den nachgeordneten Patentansprüchen beansprucht und werden nachfolgend näher erläutert.

Die Verwendung einer Photoresistschicht mit positiven oder negativen Belichtungseigenschaften als Maskierschicht erweist sich insbesondere beim Ätzen von kleinen Strukturen als vorteilhaft. Eine Photoresistschicht kann mit Standardmethoden auf den Siliziumwafer bzw. der Funktionsschicht aufgebracht werden und mit den gut handhabbaren Verfahren der Fototechnik strukturiert werden. Eine Resistmaske hat bei einem Ätzvorgang sowohl eine strukturierende als auch eine abdeckende Funktion. Im Rahmen des erfindungsgemäßen Verfahrens können aber auch CVD-Schichten als Maskierschicht verwendet werden, die mit Hilfe einer Resistschicht ebenfalls einfach strukturiert werden können.

In einer Variante des erfindungsgemäßen Verfahrens wird zum Maskieren eines bereits vorstrukturierten Siliziumwafers bzw. einer bereits vorstrukturierten Funktionsschicht ein Festresist in Form einer Lackfolie auf die jeweilige Oberfläche auflaminiert, wobei die bereits erzeugten Strukturen abgedeckt aber nicht ausgekleidet werden. Mit einer Lackfolie lassen sich sowohl Feinstrukturen als auch Grobstrukturen einfach und zuverlässig abdecken, da diese Art der Maskierung unabhängig von der bereits erzeugten, zu schützenden Struktur ist. Das Abdecken der bereits erzeugten Strukturen mit einem Festresist hat gegenüber dem Auskleiden dieser Strukturen beispielsweise mit einem Flüssigresist den Vorteil, dass die Maskierschicht an den Topographierändern nicht abreißen kann, so dass auch die besonders empfindlichen Kantenbereiche der bereits erzeugten Strukturen gut geschützt werden. Man spricht hier von einer guten Kantenbedeckung. Da das Festresist nicht in die bereits erzeugten Strukturen eindringt, ist das Entfernen einer solchen Maskierschicht auch von Feinstrukturen unproblematisch

In einigen Fällen, beispielsweise wenn zunächst die Grobstrukturen im Siliziumwafer erzeugt werden und erst danach Feinstrukturen ggf. auch im Bereich der Grobstrukturen erzeugt werden sollen, ist es von Vorteil, wenn die Maskierschicht mit der bereits erzeugten Struktur zusammenhängt. Deshalb wird die Maskierschicht in einer anderen Variante des erfindungsgemäßen Verfahrens in Form eines Flüssigresistlacks oder in Form einer CVD-Schicht auf den Siliziumwafer bzw. die Funktionsschicht aufgebracht, so dass der Flüssigresistlack in die bereits erzeugten Strukturen eindringt und diese zumindest auskleidet oder sogar vollständig ausfüllt.

Für das Aufbringen eines Flüssigresistlacks stehen verschiedene Techniken zur Verfügung, deren Eignung im wesentlichen von der Art der zu maskierenden Strukturen und deren Tiefe abhängt. Wesentlich ist, dass der Flüssigresistlack möglichst gleichmäßig in die Strukturen eingebracht wird. Bei Strukturen, deren Tiefe bis zu 5 µm beträgt, kann der Flüssigresistlack in vorteilhafter Weise in einem Spin-Coating-Verfahren auf den Siliziumwafer aufgebracht werden. Bei Strukturen, die tiefer als 5 µm sind, empfiehlt sich eine Sprühbelackung. Ein Spin-Coating ist aber auch in diesen Fällen möglich, wenn die Viskosität des Flüssigresistlacks entsprechend beeinflusst worden ist. Sowohl beim Spin-Coating als auch bei der Sprühbelackung verbessert eine Mehrfachbelackung die Kantenbedeckung und damit den Schutz der bereits erzeugten Strukturen. Eine weitere Möglichkeit besteht darin, den Flüssigresistlack mit Hilfe eines Dispensers auf den Siliziumwafer bzw. die Funktionsschicht aufzubringen bzw. in die bereits erzeugten Strukturen einzubringen. Diese Variante eignet sich besonders gut zum Ausfüllen von mikromechanischen Feinstrukturen mit Flüssigresistlack, da die Lackmengen und die Spritzpositionen des Dispensers genau definiert werden können. Dadurch kann in einem oder auch mehreren Spritzvorgängen pro Struktur jeweils exakt diejenige Schutzlackmenge über den Strukturen platziert werden, die zum ebenen Befüllen der Strukturen erforderlich ist.

Grundsätzlich können die Strukturen im Rahmen des erfindungsgemäßen Verfahrens sowohl mit isotropen als auch mit anisotropen Ätzverfahren erzeugt werden. Besonders viele Strukturierungsmöglichkeiten bieten anisotrope Ätzverfahren, wie z.B. das auch unter der Bezeichnung Plasma RIE bekannte Trenchen, bei dem der Ätzangriff im wesentlichen nur senkrecht zur Angriffsoberfläche, d.h. in die Tiefe, gerichtet ist. Deshalb wird der Siliziumwafer bzw. die Funktionsschicht in einer vorteilhaften Variante des erfindungsgemäßen Verfahrens mindestens einem Trenchvorgang unterzogen.

Maskierschichten in Form einer Photoresistschicht ― Festresist oder Flüssigresist - lassen sich sowohl trockenchemisch, beispielsweise in einem O2-Plasmastripper, als auch nasschemisch mit Hilfe eines geeigneten Lösungsmittels entfernen. Da beim trockenen Entfernen der Resistschicht Partikel auf der Waferoberfläche zurückbleiben können, die sich sowohl bei einer nachfolgenden Maskierung als auch bei einem nachfolgenden Ätzvorgang störend auswirken können, empfiehlt sich der Einsatz eines nasschemischen Verfahrens. Als besonders zuverlässig erweist sich eine Kombination aus trockenchemischer Entfernung mit nachfolgender nasschemischer Entfernung.

Durch die Entkopplung der einzelnen Ätzvorgänge bietet das erfindungsgemäße Verfahren die Möglichkeit, die Feinstruktur des Siliziumwafers bzw. der Funktionsschicht vor der Grobstruktur zu erzeugen. Außerdem können nun auch Feinstrukturen im Bereich einer bereits erzeugten Grobstruktur erzeugt werden. Da das erfindungsgemäße Verfahren sowohl auf die Vorderseite als auch auf die Rückseite eines Siliziumwafers oder auch eines Schichtaufbaus angewendet werden kann, können durch Kombination von Strukturen, die von den beiden Hauptoberflächen ausgehend erzeugt worden sind, Strukturen erzeugt werden, die sich über die gesamte Dicke des Siliziumwafers bzw. des Schichtaufbaus erstrecken. Auf diese Weise lassen sich auch sehr einfach Verbindungsstege zwischen bereits vorprozessierten Chips zum Vereinzeln dieser Chips erzeugen.

### Zeichnungen

Wie bereits voranstehend ausführlich erörtert, gibt es verschiedene Möglichkeiten, die Lehre der vorliegenden Erfindung in vorteilhafter Weise auszugestalten und weiterzubilden. Dazu wird einerseits auf die dem Patentanspruch 1 nachgeordneten Patentansprüche und andererseits auf die nachfolgende Beschreibung mehrerer Varianten der Erfindung anhand der Zeichnungen verwiesen.
- Fig. 1: veranschaulicht einige Strukturierungsmöglichkeiten des erfindungsgemäßen Verfahrens anhand der Schnittdarstellung eines Siliziumwafers,
- Fig. 2: veranschaulicht weitere Strukturierungsmöglichkeiten des erfindungsgemäßen Verfahrens anhand der Schnittdarstellung eines weiteren Siliziumwafers,
- Fig. 3: zeigt die Schnittdarstellung eines Siliziumwafers mit vorprozessierten Chips,
- Fig. 4: zeigt eine perspektivische Darstellung eines Siliziumwafers mit vorprozessierten Chips und
- Fig. 5: veranschaulicht zwei unterschiedliche Varianten des erfindungsgemäßen Verfahrens zum Erzeugen einer bestimmten Struktur in einem Siliziumwafer.

### Beschreibung der Ausführungsbeispiele

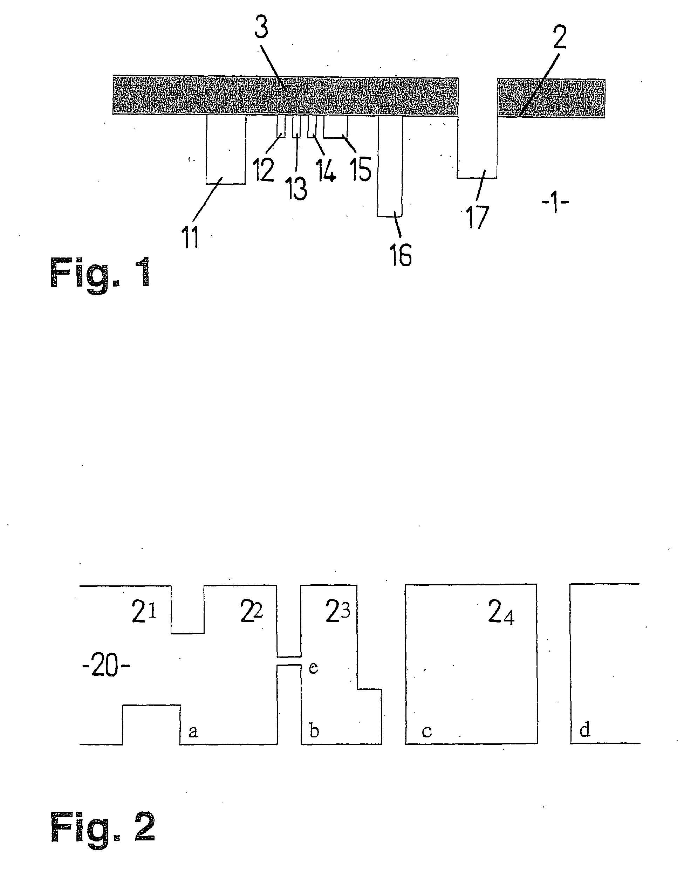

Fig. 1 zeigt einen Siliziumwafer 1, dessen Oberfläche 2 mit Ätzausnehmungen 11 bis 17 unterschiedlicher Breite und Tiefe versehen ist. Diese Ätzausnehmungen 11 bis 17 sind mit Hilfe des erfindungsgemäßen Verfahrens in vier aufeinanderfolgenden und voneinander unabhängigen Trenchvorgängen erzeugt worden und weisen dementsprechend senkrecht zur Oberfläche 2 orientierte Seitenwandungen auf. Vor jedem dieser vier Trenchvorgänge wurde eine Maskierschicht auf die Oberfläche 2 des Siliziumwafers 1 aufgebracht. Die erste Maskierschicht wurde so strukturiert, dass im ersten Trenchvorgang lediglich die Feinstruktur in Form der Ätzausnehmungen 12 bis 15 erzeugt wurde. Danach wurde die erste Maskierschicht entfernt. In einem weiteren Ätzvorgang wurde die Ätzausnehmung 11 erzeugt, die wesentlich breiter und tiefer ist als die Ätzausnehmungen 12 bis 15 der Feinstruktur. Dazu wurde die Oberfläche 2 des Siliziumwafers 1 erneut maskiert, so dass die Feinstruktur gegen den nachfolgenden Ätzangriff geschützt war. Diese zweite Maskierschicht wurde nun zum Trenchen der Ätzausnehmung 11 strukturiert, also so, dass ausschließlich im Bereich der zu erzeugenden Ätzausnehmung 11 ein Ätzangriff stattfinden konnte. Nach diesem zweiten Trenchvorgang wurde die zweite Maskierschicht wieder entfernt. Dieselbe Vorgehensweise wurde zum Erzeugen der Ätzausnehmung 16 wiederholt, wobei mit der dritten Maskierschicht nun nicht nur die Feinstruktur sondern auch die Ätzausnehmung 11 abgedeckt und so gegen einen weiteren Ätzangriff geschützt wurde. Die Ätzausnehmung 16 ist schmaler aber tiefer als die Ätzausnehmung 11, so dass der dritte Trenchvorgang vermutlich länger gedauert hat als der zweite Trenchvorgang. Danach wurde auch die dritte Maskierschicht wieder entfernt. In Fig. 1 ist der Siliziumwafer 1 nach dem vierten Trenchvorgang, in dem lediglich die Ätzausnehmung 17 erzeugt worden ist, aber vor dem Entfernen der vierten Maskierschicht 3 dargestellt.

Das erfindungsgemäße Verfahren, bei dem die einzelnen Ätzvorgänge vollkommen unabhängig voneinander sind, bietet zum einen die Möglichkeit, die Abfolge der einzelnen Ätzvorgänge beliebig zu variieren. D.h. es können nun feinere Strukturen vor gröberen Strukturen genauso wie auch gröbere Strukturen vor feineren Strukturen in einem Siliziumwafer erzeugt werden. Zum anderen können beliebig viele Ätzvorgänge nacheinander durchgeführt werden, ohne dass dabei einmal erzeugte Strukturen unkontrolliert verändert werden. Auf diese Weise können in einem Siliziumwafer problemlos Ätzausnehmungen verschiedener Tiefe und damit auch relativ komplexe Strukturen erzeugt werden.

Das erfindungsgemäße Verfahren bietet ferner die Möglichkeit, voneinander unabhängige Strukturen in die Vorderseite und in die Rückseite eines Siliziumwafers zu ätzen und diese Strukturen miteinander zu kombinieren, was durch Fig. 2 veranschaulicht wird. Hier ist ein Siliziumwafer 20 dargestellt, in dessen Vorderseite Ätzausnehmungen 21 bis 24 und in dessen Rückseite Ätzausnehmungen a bis d getrencht worden sind. Eine Verbindung von Strukturen der Vorderseite und der Rückseite ist exemplarisch an den Kombinationen der Ätzausnehmungen 23 und c sowie 24 und d zu sehen. Außerdem ist hier mit e eine Membran bezeichnet, wie sie je nach Art des zweiseitigen Ätzangriffs in beliebiger Tiefe eines Siliziumwafers erzeugt werden kann. Die Dicke der Membran e wird durch die Kombination der Tiefen der Ätzausnehmungen 22 und b definiert.

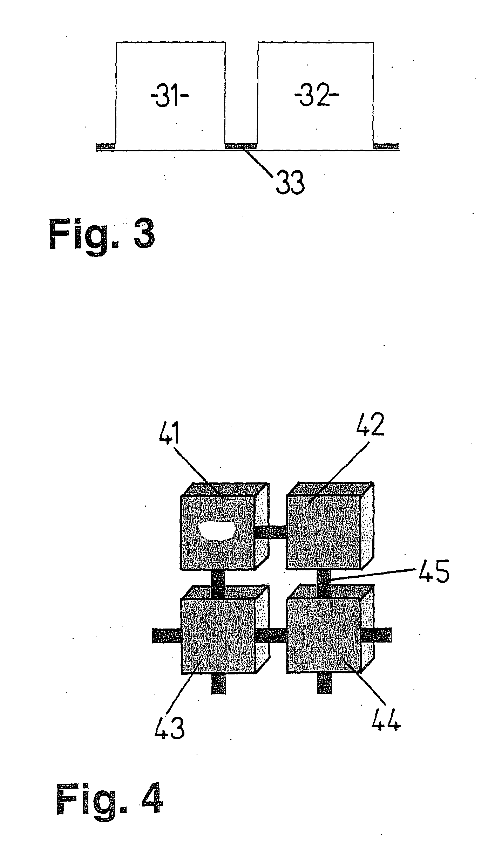

Das erfindungsgemäße Verfahren kann auch zum Strukturieren eines Siliziumwafers mit vorprozessierten Chips eingesetzt werden, um die Chips zu vereinzeln, was durch die Figuren 3 und 4 veranschaulicht wird. Bei der in Fig. 3 dargestellten Variante wurde die Vorderseite des Siliziumwafers maskiert, so dass die vorprozessierten Chips 31 und 32 gegen einen Ätzangriff geschützt waren. Dann wurde das Silizium in den Zwischenräumen zwischen den Chips in einem Trenchvorgang bis zu einer bestimmten Tiefe herausgeätzt, so dass die Chips 31 und 32 nur noch über dünne Siliziumstege 33 miteinander verbunden sind. Alternativ dazu kann der Trenchvorgang auch auf einem anderen Material gestoppt werden, wie z.B. auf einem Oxid oder auf einem aufgebondeten Siliziumwafer oder Glaswafer. Zum Vereinzeln können die Chips 31 und 32 dann einfach auseinander gebrochen werden. Durch Kombination eines von der Vorderseite ausgehenden und eines von der Rückseite des Siliziumwafers ausgehenden Ätzangriffs können auch Verbindungsstege 45 zwischen den einzelnen Chips 41 bis 44 erzeugt werden, wie sie in Fig. 4 dargestellt sind.

Wie bereits erwähnt, lassen sich mit Hilfe des erfindungsgemäßen Verfahrens auch mehrstufige Strukturen in einem Siliziumwafer erzeugen, d.h. Strukturen im Bereich einer bereits erzeugten Struktur. Zwei Varianten des erfindungsgemäßen Verfahrens zum Erzeugen derartiger Strukturen werden nachfolgend in Verbindung mit den Figuren 5a und 5b erläutert, die beide einen Siliziumwafer 50 mit einer relativ breiten Ätzausnehmung 51 zeigen, von deren Bodenfläche 52 eine wesentlich schmalere, in die Tiefe gerichtete Ätzausnehmung 54 ausgeht. In beiden Fällen wurde zunächst die Ätzausnehmung 51 erzeugt, wie in Verbindung mit Fig. 1 ausführlich beschrieben. Die Ätzausnehmung 54 wurde dann bei beiden Verfahrensvarianten in einem zweiten Trenchvorgang im Bereich der Ätzausnehmung 51 erzeugt. Die Fig. 5a und 5b zeigen jeweils die Situation nach dem zweiten Trenchvorgang und vor dem Entfernen der zweiten Maskierschicht 55 bzw. 56.

Bei der in Fig. 5a dargestellten Variante wurde ein Festresist in Form einer Lackfolie 55 mit positiv- oder negativ-Belichtungseigenschaften als zweite Maskierschicht verwendet. Derartige Lackfolien lassen sich einfach, unabhängig von den bereits in der Waferoberfläche erzeugten Strukturen auf den Siliziumwafer auflaminieren und decken dann die bereits erzeugten Strukturen, hier die Ätzausnehmung 51, ab, ohne in sie einzudringen. Auf diese Weise lassen sich auch die Kanten einer bereits erzeugten Struktur gut gegen einen weiteren Ätzangriff schützen. Ein Festresist kann genauso wie eine Flüssigresistschicht mit Standardverfahren der Fototechnik, wie Belichten und Entwickeln, bearbeitet bzw. strukturiert werden. Im hier dargestellten Fall wurde die Lackfolie 55 im Bereich der zu erzeugenden Ätzausnehmung 54 entfernt, um einen Ätzangriff an der Bodenfläche 52 der Ätzausnehmung 51 zu ermöglichen. Beim anschließenden Trenchvorgang kann es hier jedoch ― trotz teilweiser Maskierung der Ätzausnehmung 51 - zu einer Überätzung der Ätzausnehmung 51 kommen, da die Seitenwandungen 54 der Ätzausnehmung 51 ungeschützt sind.

Zum Erzeugen einer Gesamtstruktur, wie sie in den Figuren 5a und 5b dargestellt ist, kann es von Vorteil sein, wenn die zweite Maskierschicht mit der bereits erzeugten Struktur zusammenhängt, wie bei der in Fig. 5b dargestellten Variante. Dabei muss das Resist möglichst gleichmäßig in die bereits erzeugte Struktur eingebracht werden, so dass die gesamte Wandung der Struktur geschützt wird. Zum Auskleiden der Ätzausnehmung 51 wurde deshalb ein flüssiger Resistlack verwendet. Die Lackschicht 56 wurde mit Hilfe einer Projektionsbelichtung strukturiert. Dabei wurde die Lackschicht 56 lediglich auf der Bodenfläche 52 der Ätzausnehmung 51 im Bereich der zu erzeugenden Ätzausnehmung 54 entfernt, so dass auch die Seitenwandung 53 der Ätzausnehmung 51 gegen einen Ätzangriff während des anschließenden Trenchvorgangs geschützt war.

Für das voranstehend in Verbindung mit Fig. 5b beschriebene Verfahren kommen sowohl negativ- als auch positivresistive Lacke in Frage. Für positivresistive Lacke liegt die Grenze bei Strukturen mit einer Tiefe von etwa 5µm, da bis in diese Tiefe durch belichtet werden kann. P-Lacke zeigen eine schlechtere Kantenbedeckung aufgrund ihres hohen Dunkelfeldabtrages während der langen Belichtungszeit. Bei n-Lacken sind hingegen oberflächennahe Belichtungen möglich, da nur freizulegende Strukturen geöffnet werden. Bei einer Belackung von Strukturen, die tiefer als 5µm sind, ist eine Sprühbelackung empfehlenswert. Ein Spin-Coating ist aber weiterhin möglich, da eine Beeinflussung der Viskosität vorgenommen werden kann. Eine Mehrfachbelackung verbessert in jedem Fall die Kantenbedeckung.

Alternativ zum Spin-Coating oder einer Sprühbelackung kann ein Flüssigresistlack auch mit Hilfe eines Dispensers durch ein- oder mehrmalige Spritzvorgänge auf den Siliziumwafer aufgebracht und insbesondere in Vertiefungen in den Waferoberflächen eingebracht werden. Die Spritzpositionen können dazu vorprogrammiert oder mittels Bildverarbeitungssystem automatisch erkannt und angefahren werden. Mit Hilfe eines Dispensers können die bereits erzeugten mikromechanischen Strukturen auch mit dem Schutzlack zudispenst werden. Da die Lackmenge und die Spritzpositionen genau definiert werden können, kann mittels eines oder mehrmaliger Spritzvorgänge pro Struktur jeweils exakt diejenige Schutzlackmenge über den Strukturen platziert werden, die zum ebenen Befüllen der Strukturen erforderlich ist.

Die Entlackung der neugeätzten Strukturen, d.h. das Entfernen der Maskierschichten, ist sowohl bei Verwendung eines Festresists als auch bei Verwendung eines Flüssigresists unkritisch. Festresistfolien lassen sich unter Umständen nicht vollständig trocken entfernen, da Teile der Laminationsschicht als Siliziumrückstände oder siliziumoxidhaltige Rückstände auf dem Wafer zurückbleiben und später als Partikelquelle wirken. Eine Festresistfolie wird daher vorteilhafterweise nasschemisch entfernt. Es ist auch möglich, den größten Teil des Resists trockenchemisch, beispielsweise in einem Sauerstoffplasmastripper, zu entfernen, die Laminatreste anschließend nasschemische zu entfernen und ggf. die verbleibenden organischen Reste in einem weiteren trockenchemischen Prozess vollständig zu entfernen. Auch Flüssigresist lässt sich vorteilhafterweise in einem kombinierten trockenchemischen und nasschemischen Prozess entfernen.

### Bezugszeichen

- 1: Siliziumwafer
- 2: Waferoberfläche
- 3: Maskierschicht
- 11 bis 17: Ätzausnehmungen

- 20: Siliziumwafer
- 21 bis 24: Ätzausnehmungen
- a bis d: Ätzausnehmungen

- 31, 32: Chips
- 33: Siliziumstege

- 41 bis 44: Chips
- 45: Verbindungsstege

- 50: Siliziumwafer
- 51: Ätzausnehmung
- 52: Bodenfläche
- 53: Seitenwandung
- 54: Ätzausnehmung
- 55: Maskierschicht
- 56: Maskierschicht

## Patentansprüche

1. Verfahren zum Erzeugen von mikromechanischen Strukturen (11 bis 17) in einem Siliziumwafer (1) oder in der Funktionsschicht eines Schichtaufbaus für Oberflächenmikromechanik,
- wobei der Siliziumwafer (1) bzw. die Funktionsschicht mit mindestens einer ersten Maskierschicht versehen wird, die so strukturiert wird, dass ein Teil der zu erzeugenden mikromechanischen Strukturen (11 bis 17) in einem Ätzvorgang erzeugt werden kann, und
- wobei der so maskierte Siliziumwafer (1) bzw. die so maskierte Funktionsschicht mindestens einem ersten Ätzvorgang unterzogen wird, nach dem die entsprechende erste Maskierschicht entfernt wird,
**dadurch gekennzeichnet, dass** der Siliziumwafer (1) bzw. die Funktionsschicht nach dem mindestens einen ersten Ätzvorgang und dem Entfernen der mindestens einen ersten Maskierschicht mindestens einmal
- mit einer weiteren Maskierschicht (3) versehen wird, so dass die bereits erzeugten Strukturen (11 bis 16) gegen einen weiteren Ätzangriff geschützt sind,
- die weitere Maskierschicht (3) strukturiert wird,
- der so maskierte Siliziumwafer (1) bzw. die so maskierte Funktionsschicht einem weiteren Ätzvorgang unterzogen wird und
- die weitere Maskierschicht (3) nach dem weiteren Ätzvorgang entfernt wird.

2. Verfahren nach Anspruch 1, **dadurch gekennzeichnet, dass** eine Photoresistschicht mit positiven oder negativen Belichtungseigenschaften und/oder eine CVD (chemical vapor deposition)-Schicht als Maskierschicht (3) verwendet wird.

3. Verfahren nach einem der Ansprüche 1 oder 2, **dadurch gekennzeichnet, dass** ein Festresist in Form einer Lackfolie als Maskierschicht (3) auf die Oberfläche des Siliziumwafers (1) bzw. der Funktionsschicht auflaminiert wird, wobei die bereits erzeugten mikromechanischen Strukturen (11 bis 16) abgedeckt aber nicht ausgekleidet werden.

4. Verfahren nach einem der Ansprüche 1 oder 2, **dadurch gekennzeichnet, dass** die Maskierschicht (56) durch einen Flüssigresistlack und/oder eine CVD-Schicht gebildet wird, so dass die Maskierschicht (56) die bereits erzeugten mikromechanischen Strukturen (51) zumindest auskleidet.

5. Verfahren nach Anspruch 4, **dadurch gekennzeichnet, dass** der Flüssigresistlack in einem Spin-Coating-Verfahren oder in einem Sprühbelackungsverfahren aufgebracht wird.

6. Verfahren nach einem der Ansprüche 4 oder 5, **dadurch gekennzeichnet, dass** der Flüssigresistlack mit Hilfe eines Dispensers auf den Siliziumwafer aufgebracht wird bzw. in die bereits erzeugten mikromechanischen Strukturen eingebracht wird.

7. Verfahren nach einem der Ansprüche 1 bis 6, **dadurch gekennzeichnet, dass** die mikromechanischen Strukturen (11 bis 17) zumindest teilweise durch Trenchen, d.h. in einem Plasma RIE (reactive ion etching)-Verfahren, erzeugt werden, der Siliziumwafer (1) bzw. die Funktionsschicht also mindestens einem Trenchvorgang unterzogen wird.

8. Verfahren nach einem der Ansprüche 2 bis 7, **dadurch gekennzeichnet, dass** mindestens eine Maskierschicht trockenchemisch in einem 02-Plasmastripper und/oder nasschemisch mit Hilfe mindestens eines Lösungsmittels entfernt wird.

9. Verfahren nach einem der Ansprüche 1 bis 8, **dadurch gekennzeichnet, dass** die Feinstruktur des Siliziumwafers bzw. der Funktionsschicht in einem anderen Ätzvorgang erzeugt wird als die Grobstruktur des Siliziumwafers bzw. der Funktionsschicht und dass die Feinstruktur vor der Grobstruktur erzeugt wird.

10. Verfahren nach einem der Ansprüche 1 bis 9, **dadurch gekennzeichnet, dass** sowohl in der Vorderseite als auch in der Rückseite des Siliziumwafers (20) bzw. des Schichtaufbaus Strukturen (21 bis 24; a bis d) erzeugt werden, die miteinander kombinierbar sind.

11. Verfahren nach einem der Ansprüche 1 bis 10, **dadurch gekennzeichnet, dass** im Siliziumwafer bzw. im Schichtaufbau Verbindungsstege (33; 45) zwischen bereits vorprozessierten Chips (31, 32; 41 bis 44) zum Vereinzeln dieser Chips (31, 32; 41 bis 44) erzeugt werden.

12. Verfahren nach Anspruch 11, wobei der Schichtaufbau rückseitig einen Glaswafer oder eine selektive Ätzstopschicht aufweist, **dadurch gekennzeichnet, dass** die Verbindungsstege im Glaswafer oder in der selektiven Ätzstopschicht erzeugt werden.
